# EUROPEAN PATENT SPECIFICATION

(11) **EP 0 896 227 B1**
(45) Date of publication and mention of the grant of the patent: **08.01.2003**
(21) Application number: 98202374.9
(22) Date of filing: 15.07.1998
(51) Int. Cl.: G01R 31/02, G01R 31/04

(54) **Harness control system for civil electric installations, in particular for intercom or video intercom systems**
Kabelbaumkontrollsystem für elektrische Anlage, insbesondere für Gegensprechanlage- und Videogegensprechanlagesysteme
Système de contrôle des faisceaux de câbles pour des installations électriques, en particulier dans systèmes d'interphone et de vidéophone

(30) Priority: 05.08.1997 IT MI971887
(43) Date of publication of application: 10.02.1999
(73) Proprietor: BTICINO S.P.A., 20154 Milano (IT)
(72) Inventor: Ruffini, Stefano, 20161 Milano (IT); Daverio, Massimiliano, 22036 Erba (Como) (IT)
(74) Representative: Zanardo, Giovanni

(56) References cited:
- DE-A- 3 701 070
- US-A- 4 418 312
- US-A- 4 445 086
- US-A- 4 937 519
- PATENT ABSTRACTS OF JAPAN vol. 013, no. 173 (E-748), 24 April 1989 -& JP 64 002458 A (MATSUSHITA ELECTRIC WORKS LTD), 6 January 1989
- PATENT ABSTRACTS OF JAPAN vol. 095, no. 007, 31 August 1995 & JP 07 092217 A (MATSUSHITA ELECTRIC WORKS LTD), 7 April 1995

## Description

The present invention refers to a harness control system for civil electric installations in particular for intercom or video intercom systems, for access, safety and, in general, signal controls.

Currently, the control of the working conditions of an intercom or of a video intercom system of a civil building is done, after the harness of the entire system has been laid down, through a direct control of the quality of the communication between a technician, who sends test messages from the external location, and at least another operator, who receives the messages coming out from the inside terminals placed in the various floors of the building.

Then, said control has to be performed as many times as the number of internal units placed in the system and therefore, sometimes, especially in case of large residential buildings, it would be better to reduce said number of controls.

Further, the way said controls are done has some disadvantages; first of all, the control is done when the harness has been completed and therefore a malfunction would require the operators to disassemble what had been previously set up; secondly, finding a malfunction or an interruption in the communication between the external location and an internal unit does not give any information in order to locate the fault, and thus the technicians have to thoroughly control the whole connection line.

Finally, said control of the traditional type has to be conducted by at least two technicians, who exchange information on the quality of the reception of the transmitted message, generally by voice, if the distance between the external location and the internal unit allows such exchange by voice, or, otherwise, through a cellular phone, with consequent losses of time, telephone expenses, cost of personnel, possibility of mistakes and misunderstandings during the communication.

A purpose of the present invention is to solve the above mentioned problems and in particular to indicate a harness control system for civil electric plants, in particular for intercom and/or video intercom systems, said system assuring a high flexibility of the electrical and/or electronic functions, and, at the same time, allowing to control the connections of the entire system in its open circuit conditions, i.e. before the final laying.

Another purpose of the present invention is to provide a harness control system for intercom or video intercom systems such to control the connections between external locations and internal units even for short lengths of wiring, in order to locate possible installation faults or errors.

Another purpose of the present invention is to provide a harness control system for video intercom systems of the digital type.

A further purpose of the present invention is to provide a harness control system for intercom and for video intercom systems, so as to indicate installation defects to the user (cut wires, short circuited wires, inverted wires, wrong call) both in the case of call signal wires and of different types of wires.

A further purpose of the present invention is to provide a harness control system for intercom and for video intercom systems, whereby a system can be provided without using complex electric or electronic technologies and/or expensive materials.

Said purposes are achieved by a harness control system for civil electric plants, in particular for intercom and/or video intercom systems, as claimed in claim 1, which is indicated for reference.

Advantageously, the system according to the invention comprises at least an electric signal transmitter, connected to a power supply, which, during the control phase of the working conditions of the electric plant, is installed in place of the external push-button panel, so as to send electric signals through the wires.

Additionally, the system comprises a plurality of electric signal receiving means, wherein the receiving frequency is tuned with the transmitted signal frequency, said receiving means being installed in place of the intercom internal units and are used to formulate the diagnosis.

The present invention is based on the principle that, if neither faults nor malfunctions are present on the connection lines, a signal transmitted as an input into the system has to be found as an identical output signal.

A plurality of electronic reception stages and a decoder, provided with internal decoding logic, are provided to indicate the level of the signals received at the internal units and to direct said levels to the seven segments of a display with one alphanumeric figure, so that their starting sequence is driven by the sequence of said levels.

Additional features and advantages of the invention will be more evident from the description of a preferred, non-limiting embodiment of a harness control system for intercom and/or video intercom systems, according to the present invention, said system being illustrated, as a non-limiting example, in the accompanying schematic drawings, in which:

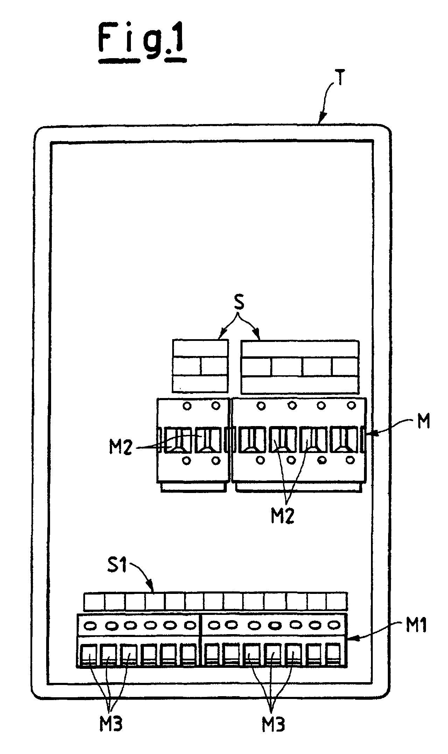

Figure 1 is a front view of an example of embodiment of a transmitter means used in the harness control system, according to the present invention;

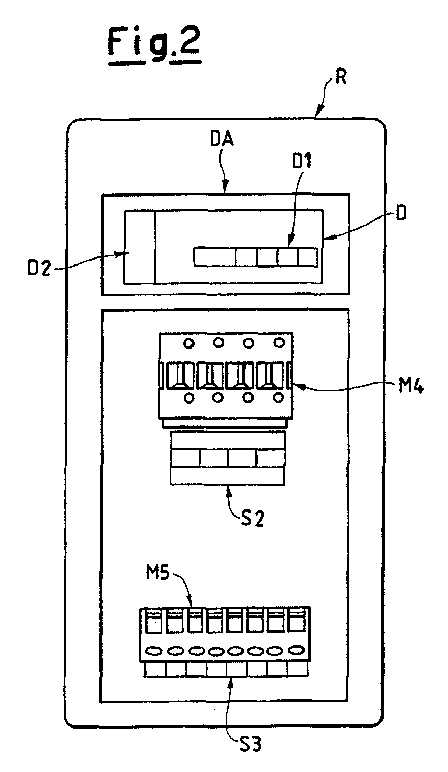

Figure 2 is a front view of an example of embodiment of a receiver means used in the harness control system, according to the present invention;
Figure 3 is a schematic view of a possible embodiment of a harness installation of an intercom system;
Figure 4 is a schematic view of a possible embodiment of a harness installation of a video intercom system;

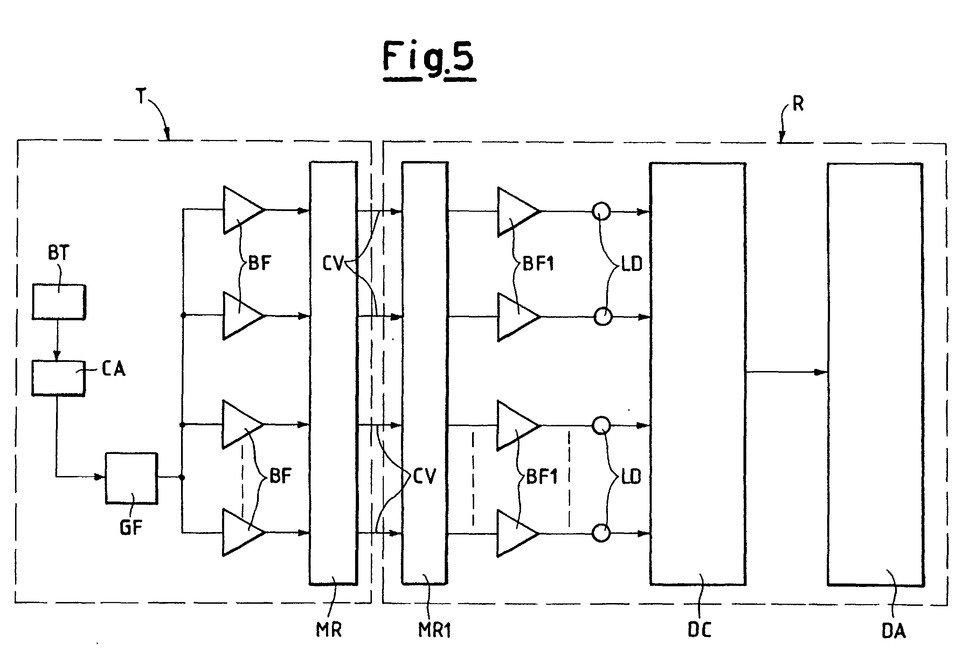

Figure 5 is a block diagram of the harness control system for electric plants, in particular for intercom and/or video intercom systems, according to the present invention;
Figure 6 shows a diagram of the electric signal waveforms in function of time, which are sent to all the system wires.

With reference to the above figures, T indicates the electric signal transmitter, M indicates a pull-out terminal board of the transmitter T, M2 indicates the terminals of said terminal board M, whilst M1 indicates a fixed terminal board of the transmitter T having pressure terminals M3.

Further, S and S1 indicate silk-screened plates, which indicate the exact relation between electric wires and terminals and which are useful for the proper insertion of the system cables into the terminals M2, M3.

R indicates a receiver of electric signals, comprising a pull-out terminal board M4, a fixed terminal board M5, a first area D of a display screen, wherein a series of LED diodes turn on in sequence, a second area D2 of the display screen to visualise alpha-numeric characters and silk-screened plates D1, S2, S3 to properly connect the electric cables of the plant to the terminals of the terminal board M4, M5; in fact, thanks to these bijection tables, it is possible to control the working conditions of any type of intercom and/or video-intercom system.

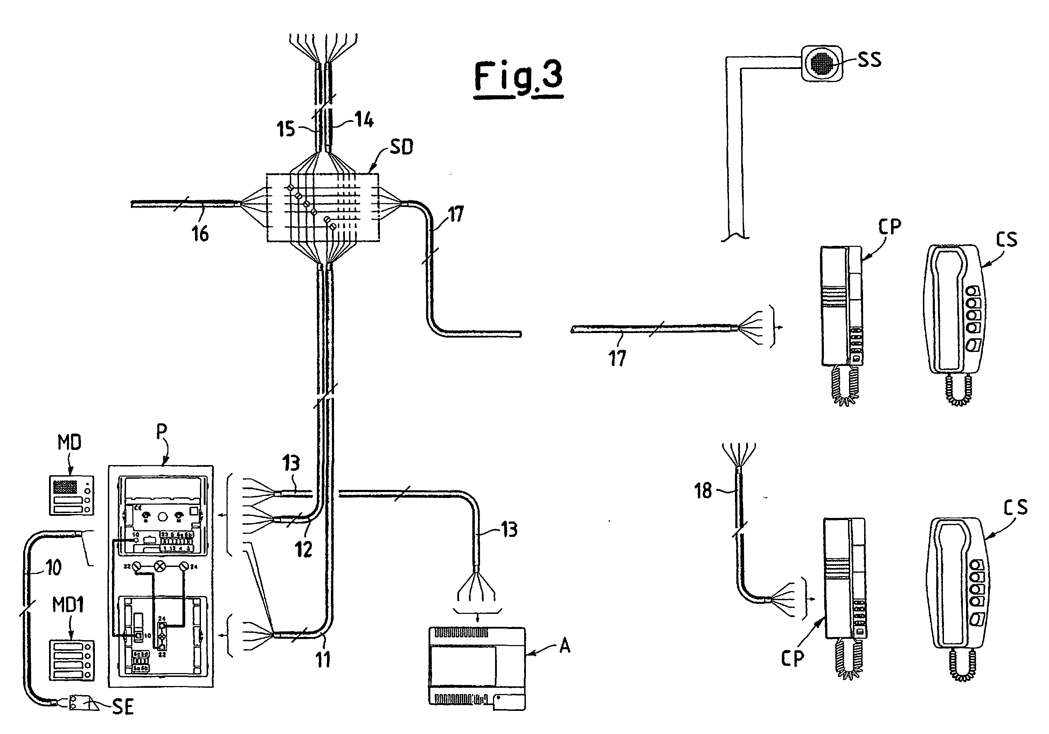

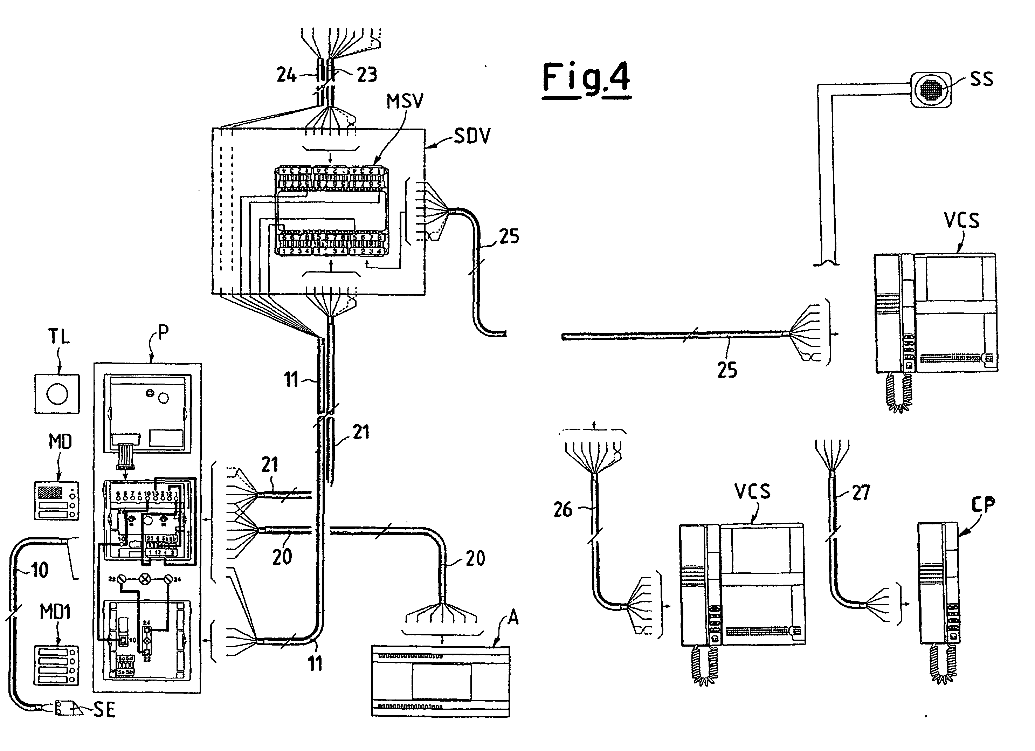

Referring in particular to Figures 3 and 4, MD and MD1 indicate, for instance, two call modules (one module with two push-buttons and a loudspeaker and the other module with four push-buttons), which can be present in a modular push-button panel P of an external location for calling the floors; 10 indicates an electric double-wire-cable which connects the push-button panel P to an electric lock SE of the building main-gate, 13 indicates a four-wire-electric cable which connects the push-button panel P to a power supply A, whilst SD indicates a shunt module which connects a plurality of internal units; 11 and 12 indicate, respectively, an "n" wire (wherein n is the number of internal units connected to the push-button panel P) and a four-wire-electric cable, which connect the push-button panel P to the shunt module SD, whilst 14 and 15 indicate two cables (having 4+n wires inside) coming out from the SD module.

16 indicates a five-wire-electric cable, which connects the SD module to a possible second internal unit; 17 indicates a five-wire-electric cable, which connects the SD module to a first internal location on the plane and, then, to the internal units CP, CS; SS indicates a possible additional signal bell; whilst 18 indicates a five-wire-shunt cable for connecting a possible second internal unit CP, CS parallel to the first.

In the case of a video intercom installation, as shown in Figure 4, the cable connections are similar and the functional blocks indicated by the same reference, compared to Figure 3, have the same features.

The only differences consist in adding a camera module, indicated by TL and positioned on the push-button panel P, in the type of the internal units (the ones with the display screen are indicated with VCS), in the shunt module SDV, provided with a terminal board MSV and in the number of electric wires which are inside the cables.

20 indicates a seven-wire-electric cable, which connects the push-button panel P to the power supply A, 21 indicates a seven-wire-electric cable which connects the push-button panel P to the module SDV; 23 and 24 indicate two cables with seven and n wires, respectively, wherein n is the number of internal units connected to the push-button panel P, and said cables come out from the module SDV; 25 indicates an eight-wire-electric cable, which connects the module SDV to a first inside location provided with internal units VCS; 26 and 27 indicate an eight and a five-wire-electric cables, which connect, in parallel, an output of the shunt device on the plane to a video intercom internal unit VCS and to an intercom internal unit CP.

The transmitter apparatus T comprises an accumulator battery BT, connected to a power supply circuit CA and to a waveform generator GF; the transmission device further comprises a series of input buffers (equal, in number, to the number of wires to be controlled) and a terminal board MR for sending the electric signals.

In a non-limiting, preferred embodiment of the present invention, the number of the system wires CV, which can be controlled simultaneously, is equal to 10, plus the call wires.

In such case, if the number of the system wires is greater than ten, a corresponding number of equal control operations will be conducted, one after the other, on the remaining wires to be controlled.

The receiver R comprises a final terminal board MR1, a receiver device, comprising a series of buffers BF1 (equal, in number, to the number of wires to be controlled), a series of indicators LD of the level of the incoming electric signal, a decoder device DC, which sends the electric signal level to the segments of the zone D2 of the screen DA, wherein alphanumeric characters are visualised.

In order to control the proper connections of a civil electric plant, in particular an intercom or a video intercom, the following procedure is followed.

Before connecting the electric cables to the ends of the plant and, therefore, through an open circuit operation, the transmitter T is positioned in place of the push-button panel P of the external location, i.e. at the beginning of each harness section wherein the control is desired.

The receiver R can be positioned in place of each internal unit CS, CP, VCS (direct connection) or at the end of each section to be controlled (indirect connections).

Also the transmitter T can be moved along the harness, so as to control the connections on the shorter sections; in fact, the harness sections to be controlled can have, at will, very short distances, in order to locate the problem more easily, through a put and take process.

In this way, the electrical connections of the power supply A and of the plant wires, which carry the electric signal, including the call wires.

This is obtained by sending inside the wires a waveform generated by the generator GF and by evaluating the parameters of the waveform received as an output; preferably, a square wave is sent to each one of the electric cables to be controlled, but, alternatively, a different waveform could be sent to some or to all the connection wires. Further, also the signal type can be changed (from square wave to triangular wave, to sawtoothed wave, to ramp waveform and so on), as long as the duration of the generated pulse is sufficient to keep lighted a display device, as for instance a LED diode, for a period of time at least equal to the persistence of vision in the human eye retina, so as to allow a user to notice the various lighting.

In a non-limiting and exemplifying embodiment, the duration of the pulse is equal to at least one second and the amplitude of the square wave is equal to 3-9 Volt (including the extreme values).

The connections of the transmitter T are executed by placing the electric cables of the plant on the terminal boards M, M1 in the order established by the plates S, S1 and, therefore, the waveforms are sent to each wire.

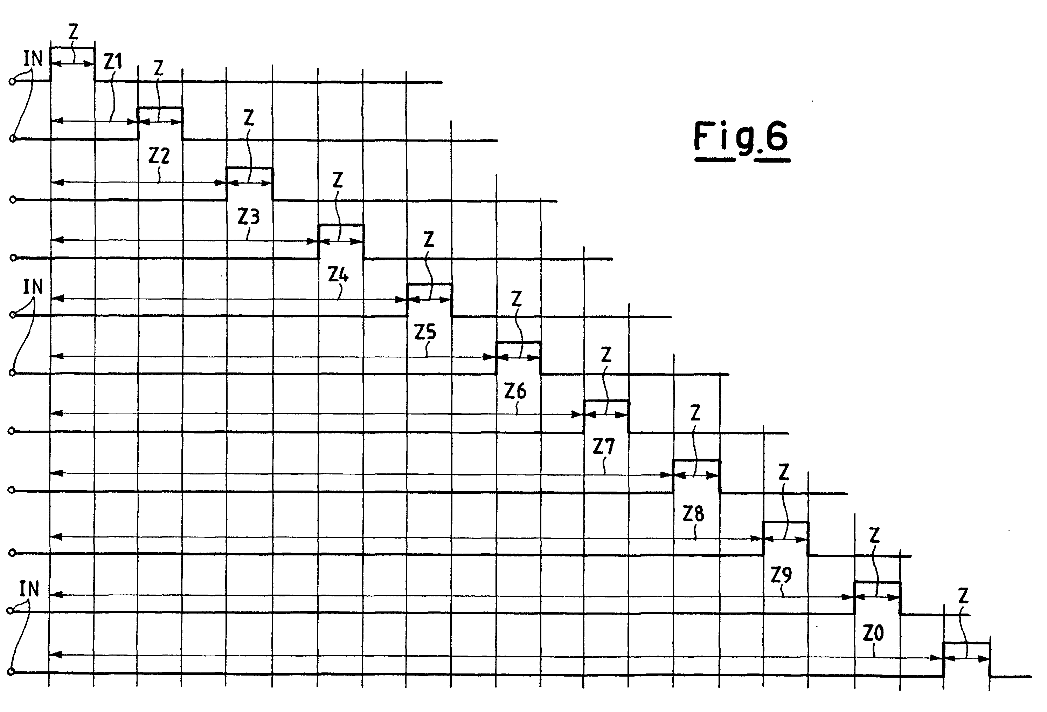

Usually, ten wires are connected, plus the call wires, and the receiver is able to recognise the levels of the received signals; a microcontrol placed inside the decoder DC executes a reading of the signals on every input IN of the wires to be controlled, following the sequence illustrated in Figure 6, wherein Z is the duration of the square wave (equal, for instance to one second) and Z1, Z2, Z3, Z4, Z5, Z6, Z7, Z8, Z9, Z0 are the time periods whereby the square wave is delayed at the various inputs IN (in this case, Z0 is equal to about 20 seconds).

Said sequence is necessary to sequentially light the LED diodes of the display screen DA; in fact, the decoder electronic circuit DC senses the levels of the input signals and sends said levels to the screen DA, so as to drive or do not drive the lighting of the LED diode (or LED diodes) corresponding to the electric cable (or cables) where an anomaly has been found.

If the connections have been executed properly, all the LED diodes of the screen DA should light in sequence (i.e., starting from the second LED, at two, four, six, eight, ten, twelve, fourteen, sixteen, eighteen and twenty seconds after the first LED lights, respectively).

If this does not happen, various cases can happen, said cases are herein examined: if the LED diode adjacent to the number of the electric cable indicated on the silk-screened plate D1 does not light, it means that the electric cable itself is interrupted; if two or more LED diodes light, it means that the corresponding electric cables are short circuited, while if the LED diodes do not light in the programmed sequence, it means that the corresponding electric cables are inverted.

In the traditional intercom plants, the call push-buttons can be grouped in modules of four push-buttons, therefore, in such case, it is convenient to provide an area D2 of the screen DA wherein a seven segments alphanumeric character is displayed, corresponding to the group of four call push-buttons under examination.

Obviously, if the connection between the transmitter T and the receiver R refers to a specific group of call wires, the corresponding letter (a, b, c, d) shall appear in the area D2; otherwise, if the visualised letter does not match the push button group from which the call is originated, that is sign of a connection error.

However, it is important that the sequential orderly lighting of the LED diodes precedes the lighting of the letter segments corresponding to the group of the call push-button, so that the technician who installs the system can conduct the controls one at a time, without mixing the operations and the results and by paying attention first to the LED and, subsequently, to the alphanumeric display.

As is clearly seen from Figures 3 and 4, the circuit scheme of an intercom system comprises a shunt device SD, which allows the connection of a plurality of internal places, to start from the plane shunt; said apparatus is simple to provide and works in a substantially known manner.

On the contrary, the shunt device SDV of a video intercom system (Figure 4) is much more complex, since the number of electric cables to be connected together is much higher; then, in order to control the harness of the video intercom systems, the shunt device SDV can be substituted by a specific device, which has to be connected with the transmitter T and the receiver R.

It has to be noticed once again the fact that the transmitter T and the receiver R are provided with fixed and/or removable terminal boards, so as to adapt to different types of electric systems and that the diagnosis can be done also with systems of the digital type, section by section, by means of wired terminal boards.

Finally, it should be understood that, through such a solution, it is necessary to feed only the transmitter T and not also the receiver R.

From the above description, the features and the advantages of the harness control system for civil electric plants, in particular for intercom and/or video intercom systems, according to the present invention are clear.

The advantages are, in particular, the following:
- a simple control and diagnosis procedure for anomalies which can be present in the harness of an electric plant; further, said control and diagnosis procedure can be assigned to just one operator;
- possibility of intervening in a short time to solve the problem, without having to completely disassemble the plant;
- possibility of locating the anomaly in the wires, through a put and take technique;
- operation costs substantially reduced in comparison to the known art;
- flexibility of use and all-purpose use.

It is clear that several changes can be done to the harness control system by the skilled in the art, in particular to the intercom and video intercom systems, which are the subject of the present invention, without leaving the scope of protection of the invention as defined in the claims, it is also clear that, in the embodiments of the invention, the shapes of the illustrated details can be different and these same details can be substituted by technically equivalent elements.

## Claims

1. Harness control apparatus for an analogue or digital intercom and video intercom systems installed in a building, comprising a transmitter device (T), which replaces an external unit (P) of the intercom system, for transmitting electric signals through at least one portion of a multi-conductor (CV) cable of said intercom system, said signals being emitted by said transmitter device (T) and being received by a receiver device (R), which replaces an internal unit (CS, CP, VCS) of the intercom system, said receiver device (R) being set on a value of frequency depending on the frequency of the signals emitted by the transmitter device (T), wherein said receiver device (R) comprises an input stage (BF1) for treating the electric signals, decoder means (DC) for reading a signal level on every input (IN) of said multi-conductor (CV) cable and a plurality of LED diodes (LD) which flash automatically in a given sequence to visualise wiring errors on a screen (DA) of the receiver device (R), said decoder means (DC) being provided for actuating an alphanumeric display (DA) of the receiver device (R), which visualises digits or characters related to a prefixed group of call push-buttons of the intercom system, on the basis of said signal level provided on said inputs (IN) of the multi-conductor (CV) cable, said visualisation of digits or characters being provided after said flashing of the LED diodes (LD).

2. Harness control apparatus as claimed in claim 1, **characterised in that** said transmitter device (T) comprises a power supply source (BT), a power supply circuit (CA), a waveform generator (GF) for generating said electric signals and an output stage (BF) for sending said electric signals through the multi-conductor (CV) cable.

3. Harness control apparatus as claimed in claim 2, **characterised in that** said electric signals are constituted by given square waves, which have a defined pulse duration of at least one second and an amplitude value comprised between 3 and 9 Volt, said square waves having different periods.

4. Harness control apparatus as claimed in claim 1, **characterised in that** each LED diode (LD) is connected to one conductor of the multi-conductor (CV) cable, so that if a first diode does not flash it means that the relative conductor is interrupted, while if at least two second diodes flashes simultaneously it means that relative conductors are short circuited, and if third diodes flash with a different sequence with respect to said given sequence it means that at least two of relative conductors are inverted.

## Patentansprüche

1. Kabelbaumkontrollsystem für analoge oder digitale Gegensprech- und Videogegensprechanlagesysteme, die in einem Gebäude installiert sind, mit einer Sendervorrichtung (T), die eine externe Einheit (P) des Gegensprechanlagesystems ersetzt, zum Senden von elektrischen Signalen über mindestens einen Abschnitt eines Mehrleiter-(CV-)Kabels des Gegensprechanlagesystems, wobei das Signal von der Sendervorrichtung (T) gesendet und von einer Empfängervorrichtung (R) empfangen wird, die eine interne Einheit (CS, CP, VCS) des Gegensprechanlagesystems ersetzt, wobei die Empfängervorrichtung (R) in Abhängigkeit von der Frequenz der Signale, die von der Sendervorrichtung (T) gesendet werden, auf einen Frequenzwert gesetzt wird, wobei die Empfängervorrichtung (R) eine Eingangsstufe (BF1) zur Behandlung der elektrischen Signale, eine Decodierereinrichtung (DC) zum Lesen eines Signalpegels an jedem Eingang (IN) des Mehrleiter-(CV-)Kabels und mehrere LED-Dioden (LD) aufweist, die in einer gegebenen Abfolge automatisch aufleuchten, um Leitungsfehler auf einem Bildschirm (DA) der Empfängervorrichtung (R) sichtbar zu machen, wobei die Decodierereinrichtung (DC) zum Auslösen einer alphanumerischen Anzeige (DA) der Empfängervorrichtung (R) vorgesehen ist, die Ziffern oder Zeichen, die sich auf eine vorher festgelegte Gruppe von Ruftasten des Gegensprechanlagesystems beziehen, auf der Grundlage des Signalpegels sichtbar macht, die an den Eingängen (IN) des Mehrleiter-(CV-)Kabels vorliegen, wobei die Sichtbarmachung von Ziffern oder Zeichen nach dem Aufleuchten der LED-Dioden (LD) erfolgt.

2. Kabelbaumkontrollsystem nach Anspruch 1, **dadurch gekennzeichnet, daß** die Sendervorrichtung (T) eine Stromquelle (BT), eine Stromversorgungsschaltung (CA), einen Wellenformgenerator (GF) zur Erzeugung von elektrischen Signalen und eine Ausgangsstufe (BF) zum Senden der elektrischen Signale über das Mehrleiter-(CV-)Kabel aufweist.

3. Kabelbaumkontrollsystem nach Anspruch 2, **dadurch gekennzeichnet, daß** die elektrischen Signale aus gegebenen Rechteckwellen bestehen, die eine definierte Impulsdauer von mindestens einer Sekunde und einen Amplitudenwert zwischen 3 und 9 Volt haben, wobei die Rechteckwellen verschiedene Perioden haben.

4. Kabelbaumkontrollsystem nach Anspruch 1, **dadurch gekennzeichnet, daß** jede LED-Diode (LD) mit einem Leiter des Mehrleiter-(CV-) Kabels verbunden ist, so daß, wenn eine erste Diode nicht aufleuchtet, dies bedeutet, daß der betreffende Leiter unterbrochen ist, und wenn mindestens zwei zweite Dioden gleichzeitig aufleuchten, dies bedeutet, daß betreffende Leiter kurzgeschlossen sind, und wenn dritte Dioden in einer anderen Abfolge in bezug auf die gegebene Abfolge aufleuchten, dies bedeutet, daß mindestens zwei der betreffenden Leiter verkehrt sind.

## Revendications

1. Dispositif de contrôle de faisceau de câbles pour des système d'interphones et de vidéophones analogiques ou numériques installés dans un bâtiment, comprenant un dispositif émetteur (T) qui remplace une unité externe (P) du système d'interphone, pour transmettre des signaux électriques par au moins une partie d'un câble à conducteurs multiples (CV) dudit système d'interphone, lesdits signaux étant émis par ledit dispositif émetteur (T) et étant reçus par un dispositif récepteur (R) qui remplace une unité interne (CS, CP, VCS) du système d'interphone, ledit dispositif récepteur (R) étant réglé sur une valeur de fréquence en fonction d'une fréquence des signaux émis par le dispositif émetteur (T), et dans lequel ledit dispositif récepteur (R) comprend un étage d'entrée (BF1) pour traiter les signaux électriques, des moyens décodeurs (DC) pour lire un niveau de signal appliqué à chaque entrée (IN) dudit câble à conducteurs multiples (CV) et une pluralité de diodes LED (LD) qui clignotent automatiquement selon une séquence donnée pour visualiser des erreurs de câblage sur un écran (DA) du dispositif récepteur (R), lesdits moyens décodeur (DC) étant prévus pour actionner un dispositif d'affichage alphanumérique (DA) du dispositif récepteur (R) qui visualise des chiffres ou des caractères associés à un groupe fixé à l'avance de boutons-poussoirs d'appel du système d'interphone, sur la base dudit niveau du signal appliqué auxdites entrées (IN) du câble à conducteurs multiples (CV), ladite visualisation de chiffres et de caractères étant fournie après ledit clignotement des diodes LED (LD).

2. Dispositif de contrôle de faisceau selon la revendication 1, **caractérisé en ce que** ledit dispositif émetteur (T) comprend une source d'alimentation en énergie (BT), un circuit d'alimentation en énergie (CA), un générateur de formes d'ondes (GF) pour produire lesdits signaux électriques et un étage de sortie (BF) pour émettre lesdits signaux électriques par le câble à conducteurs multiples (CV).

3. Dispositif de contrôle de faisceau de câbles selon la revendication 2, **caractérisé en ce que** lesdits signaux électriques sont constitués par des ondes carrées données, qui possèdent une durée d'impulsions définie d'au moins une seconde et une valeur d'amplitude comprise entre 3 et 9 volts, lesdites ondes carrées ayant des périodes différentes.

4. Dispositif de contrôle de faisceau de câbles selon la revendication 1, **caractérisé en ce que** chaque diode LED (LD) est connectée à un conducteur du câble à conducteurs multiples (CV) de sorte que si une première diode ne clignote pas, cela signifie que le conducteur correspondant est interrompu, alors que si au moins deux secondes diodes clignotent simultanément cela signifie que des conducteurs correspondants sont court-circuités, et si des troisièmes diodes clignotent avec une séquence différente de ladite séquence donnée, cela signifie qu'au moins deux des conducteurs correspondants sont inversés.
